**Europäisches Patentamt**

**European Patent Office**

**Office européen des brevets**

(11) Veröffentlichungsnummer: **0 134 269**
**B1**

(12) # EUROPÄISCHE PATENTSCHRIFT

(45) Veröffentlichungstag der Patentschrift:
**07.01.88**

(51) Int. Cl.⁴: **H 01 J 37/30, H 01 J 37/317**

(21) Anmeldenummer: **83107926.4**

(22) Anmeldetag: **11.08.83**

(54) **Elektronenstrahl-Projektionslithographie.**

(43) Veröffentlichungstag der Anmeldung:
**20.03.85 Patentblatt 85/12**

(45) Bekanntmachung des Hinweises auf die Patenterteilung:
**07.01.88 Patentblatt 88/1**

(84) Benannte Vertragsstaaten:
**DE FR GB**

(56) Entgegenhaltungen:
US - A - 3 745 358
US - A - 4 194 123

PATENTS ABSTRACTS OF JAPAN, Band 4, Nr. 117
(E-22)[599], 20. August 1980, Seite 43 E 22; JP - A - 55 72
031
IBM TECHNICAL DISCLOSURE BULLETIN, Band 25, Nr.
6, November 1982, Seite 2733, Armonk, N.Y., US; U.
BEHRINGER u.a.: "Mask for X-ray lithography with
optically transparant registration window"
Electron Beam Technology, S.SCHILLER, New York,
1982

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk,
N.Y. 10504 (US)**

(84) Benannte Vertragsstaaten: **FR GB**

(72) Erfinder: **Behringer, Uwe, Dr., Dipl.-Phys.,
Wolfsbergstrasse 27, D-7403 Ammerbuch 4 (DE)**
Erfinder: **Bohlen, Harald, Dipl.-Phys., Schützenweg 77,
D-7030 Böblingen (DE)**
Erfinder: **Kulcke, Werner, Dr., Dipl.-Phys.,
Westerwaldweg 8, D-7030 Böblingen (DE)**
Erfinder: **Nehmiz, Peter, Dr., Dipl.-Phys.,
Karl-Weller-Strasse 2, D-7000 Stuttgart 80 (DE)**

(74) Vertreter: **Teufel, Fritz, Dipl.-Phys., IBM Deutschland
GmbH. Europäische Patentdienste Postfach 265,
D-8000 München 22 (DE)**

## Beschreibung

Die Erfindung betrifft eine Einrichtung zur Elektronenstrahl-Projektionslithographie nach dem Oberbegriff des Hauptanspruchs.

Die fortschreitende Miniaturisierung von integrierten Schaltungen verlangt die Erzeugung immer kleinerer Strukturen, z.B. Leiterzugbreiten. Die heute fast ausschliesslich angewandte Photolithographie erreicht bei Strukturen von ungefähr 1 μ ihre Grenzen, die durch Beugungseffekte und den sehr kleinen Schärfetiefenbereich bedingt sind. Korpuskularstrahl-optische Lithographieverfahren, z.B. mit Elektronenstrahlen oder Ionenstrahlen, ermöglichen zwar die Herstellung sehr viel feinerer Strukturen, ihrem praktischen Einsatz stehen aber noch beträchtliche technische und wirtschaftliche Probleme entgegen, beispielsweise in bezug auf den gewünschten hohen Durchsatz an zu belichtenden Halbleiterscheiben (Wafern), den apparativen Aufwand oder die relative Justierung zwischen Maske und Wafer. Ein Überblick über die heute untersuchten Einrichtungen und Verfahren gibt der Artikel von H. Braun «Lithographie mit Licht-, Elektronen- und Röntgenstrahlen» in Physik in unserer Zeit, 10. Jahrg. 1979/Nr. 3, S. 68 ff.

Unter den korpuskularstrahl-optischen Systemen haben die mit Elektronenstrahlen betriebenen bisher die weiteste Verbreitung gefunden. Bei Anwendungen, die keine hohen Stückzahlen erfordern, z.B. bei der Herstellung von Masken für die Photolithographie, werden dabei sogenannte abtastende Systeme eingesetzt, die ohne Maske arbeiten und das gewünschte Muster nach Art eines Fernsehbildes erzeugen oder nach dem sogenannten schnelleren Vektor-Scan-Verfahren. Für eine Massenfertigung von integrierten Schaltungen sind diese Systeme aber zu langsam.

Elektronenstrahl-Lithographiesysteme mit Schattenwurfprojektion (Proximity Printing), wie sie in der deutschen Patentanmeldung P 27 39 502.4 oder dem Artikel von H. Bohlen et al in Proc. 9th Int. Conf. Electron and Ion Beam Science and Technology, Vol. 80-6, 1980, S. 244 beschrieben sind, ermöglichen zwar einen hohen stündlichen Durchsatz an Wafern, da ähnlich wie bei der bekannten Photolithographie ganze Masken auf den Wafer abgebildet werden, doch erfordert die Lenkung des Elektronenstrahls über die einzelnen Teile der Maske ein relativ aufwendiges Strahlführungs- und Steuerungssystem, insbesondere wenn relativ grosse Masken verwendet werden. Andererseits kann der Querschnitt des Elektronenstrahls so gross wie die Maskenfläche gemacht werden, wie es in dem Buch «Electron Beam Technology» von Schiller, Heisig und Panzer auf S. 413 vorgeschlagen wird.

Ein weiteres Projektionsverfahren mit Elektronenstrahlen ist unter der Bezeichnung Kathodenprojektion bekannt geworden und von T.W. O'Keeffe et al in Solid-State Electronics, Bd. 12, 1969, S. 841 ff. beschrieben worden. Anstelle einer für Elektronen durchlässigen Maske wird dort eine grossflächige Photokathode durch ein Maskenmuster strukturiert und die bei Bestrahlung mit ultraviolettem Licht austretenden Elektronen durch ein elektronenoptisches Abbildungsfeld auf den Wafer abgebildet. Dieses System hat trotz seiner scheinbaren Einfachheit in der Praxis noch keine Anwendung gefunden, da Abbildungsfehler die erforderliche Genauigkeit beeinträchtigen; diese Abbildungsfehler werden unter anderem durch den Wafer selbst hervorgerufen, der bei diesem System die Anode bildet und durch seine unvermeidlichen Unebenheiten die Abbildungseigenschaften stört.

Die vorliegende Erfindung stellt sich daher die Aufgabe, ein Elektronenstrahl-Projektionssystem der eingangs genannten Art anzugeben, das bei einfachem Aufbau eine hohe Abbildungstreue und einen hohen Durchsatz an zu belichtenden Wafern ermöglicht.

Diese Aufgabe wird durch die im Hauptanspruch gekennzeichnete Erfindung gelöst; Ausgestaltungen der Erfindung sind in den Unteransprüchen gekennzeichnet.

Die Erfindung schlägt vor, die bekannten Kathoden-Projektionssysteme so abzuwandeln, dass eine unstrukturierte Photokathode verwendet wird, die bei Belichtung mit ultraviolettem Licht einen homogenen Elektronenstrom breiten Durchmessers aussendet, der unter dem Einfluss eines elektrischen Feldes kollimiert und auf eine für Elektronenstrahlen durchlässige Maske gerichtet wird, die unmittelbar vor dem Wafer nicht anliegend und parallel zu diesem angeordnet ist.

Diese Einrichtung benötigt also keine abbildenden elektronenoptischen Elemente, die einen hohen Herstellungsaufwand erfordern; die selbst dann noch unvermeidlichen Abbildungsfehler treten also hier nicht auf. Da die Abbildungsfehler normalerweise für jedes Belichtungssystem spezifisch sind, können bekannte lithographische Geräte nicht ohne weiteres gegeneinander ausgetauscht werden. Bei der hier vorgeschlagenen Einrichtung besteht diese Beschränkung nicht. Insgesamt ergibt sich somit eine sehr einfache und kompakte elektronenstrahllithographische Einrichtung, die trotzdem einen hohen Durchsatz ermöglicht, da Masken mit grossen Durchmessern verwendet werden können. In einer Ausgestaltung der Erfindung ist auch eine Feinpositionierung zwischen Maske und Wafer vorgesehen, die durch eine elektronische Neigung des von der Photokathode ausgehenden Elektronenstrahls erzielt werden kann. Auch Lithographieeinrichtungen, die nur einen Teil des Wafers belichten und an denen der Wafer Schritt für Schritt vorbeibewegt wird (sog. Step-and-Repeat-Verfahren), sind mit der hier vorgeschlagenen Einrichtung möglich. Die mit der vorgeschlagenen Einrichtung erzielbaren Linienbreiten liegen im Bereich von 0,5 μ.

Ein Ausführungsbeispiel der Erfindung wird nun anhand einer Zeichnung näher erläutert; diese zeigt in schematischer Weise den prinzipiellen Aufbau eines Elektronenstrahl-Lithographiesystems mit einer unstrukturierten Photokathode.

In einer Vakuumglocke 10, die über einen Anschluss 18 mit entsprechenden Vakuumpumpen verbunden ist, befindet sich eine Halbleiterscheibe (Wafer) 11, deren eine Oberfäche mit einer dünnen Schicht 12 eines Photolacks bedeckt ist, dessen Löslichkeitseigenschaften durch Bestrahlung mit Elektronenstrahlen verändert werden können. Das in der Photolackschicht 12 zu erzeugende Muster wird durch die Öffnungen 13a einer Transmissionsmaske 13 bestimmt, die in geringem Abstand parallel zur Oberfläche der Wafers angeordnet ist; ein typischer Wert des Abstands beträgt ungefähr 0,5 mm.

Die Transmissionsmaske 13 besteht aus einer sehr dünnen Siliciumschicht, deren Randbereiche dicker ausgebildet sind und für die mechanische Stabilität sorgen. Die für Elektronen durchsichtigen Bereiche 13a bestehen aus Löchern, die beispielsweise durch Ionenätzen in der Siliciumschicht erzeugt werden. Derartige Elektronenstrahl-Lithographiemasken sind im Stand der Technik bekannt und beispielsweise von J.Greschner et al in Proc. 9th Int. Conf. Electron and Ion Beam Science and Technology, Vol. 80-6, 1980, S. 152 ff. oder der deutschen Patentanmeldung P 29 22 416.6 beschrieben. Bei den bisher vorgeschlagenen Schattenwurf-Projektionsverfahren mit derartigen Masken wurde ein Elektronenstrahl mit einem Durchmesser verwendet, der wesentlich kleiner als die Gesamtmaske war. Zur Belichtung der Gesamtmaske musste dieser Strahl dann rasterförmig abgelenkt werden. Elektronenstrahloptische Systeme für grosse Strahldurchmesser erfordern nämlich einen sehr hohen Aufwand.

Im Gegensatz dazu schlägt die vorliegende Erfindung eine grossflächige Ausleuchtung der Transmissionsmaske 13 vor und verwendet dazu eine Photokathode mit einer entsprechend grossen Oberfläche. Die Photokathode besteht aus einer dünnen Schicht 16 eines Materials mit einer hohen Photoemission, z.B. Palladium oder Cäsiumjodid, die auf einem Träger 17 angeordnet ist, der seinerseits für ultraviolettes Licht 19 durchlässig ist, das von der Rückseite des Trägers auf die photoempfindliche Schicht gerichtet wird (beispielsweise durch eine entsprechende Öffnung in der Vakuumglocke 10).

Zwischen der photoempfindlichen Schicht 16 einerseits und dem Wafer 11 andererseits wird eine Gleichspannung der Grössenordnung 5–10 kV so angelegt, dass die photoempfindliche Schicht als Kathode wirkt und die daraus austretenden Photoelektronen (durch Pfeil 15 dargestellt) durch das entstehende homogene elektrische Feld (durch Pfeil 14 dargestellt) beschleunigt werden. Das ebene elektrische Feld 14 dient gleichzeitig zur Kollimierung des Elektronenstrahls 15, der somit senkrecht auf die Maske 13 auftrifft und einen scharfen Schattenwurf ohne Halbschattengebiete erzeugt. Um Störungen des ebenen und homogenen elektrischen Feldes 14 durch die Maske 13 zu vermeiden, wird diese auf ein derartiges Potential gelegt (z.B. mit Hilfe eines Spannungsteilers 20), dass die Maske einer Äquipotentialfäche des Feldes 14 entspricht, das zwischen Photokathode 16 und Wafer 11 vorliegt, wenn keine Maske eingebaut ist.

Der grundsätzliche Unterschied der erfindungsgemässen Einrichtung gegenüber den bekannten Kathodenstrahl-Projektionsgeräten besteht also in der Trennung der Maske von der photoemittierenden Schicht; diese wird vollkommen unstrukturiert und homogen hergestellt. Durch die Anordnung der Belichtungsmaske unmittelbar vor dem Wafer brauchen keinerlei Abbildungsbedingungen eingehalten werden, die sonst nur schwer zu erfüllen sind, wenn die aus der Photoschicht 16 austretenden Elektronen über die relativ grosse Entfernung bis zur Oberfläche des Wafers 11 punktweise abgebildet werden sollen. Ausser der Kollimationswirkung des elektrischen Feldes 14, die einen parallelen Elektronenstrahl erzeugt, sind also keinerlei weitere elektronenoptische Abbildungsmittel erforderlich.

Störungen des elektrischen Feldes durch Unebenheiten des Wafers werden bei dem hier vorgeschlagenen elektrischen Potential der Transmissionsmaske ebenfalls weitgehend vermieden.

Damit vereinigt das erfindungsgemässe System die Vorteile der bisher bekannten Elektronenstrahl-Projektionssysteme, nämlich die hohe Genauigkeit bei der Maskenprojektion und den einfachen Aufbau der Kathodenprojektion, ohne deren Nachteile mitzuübernehmen.

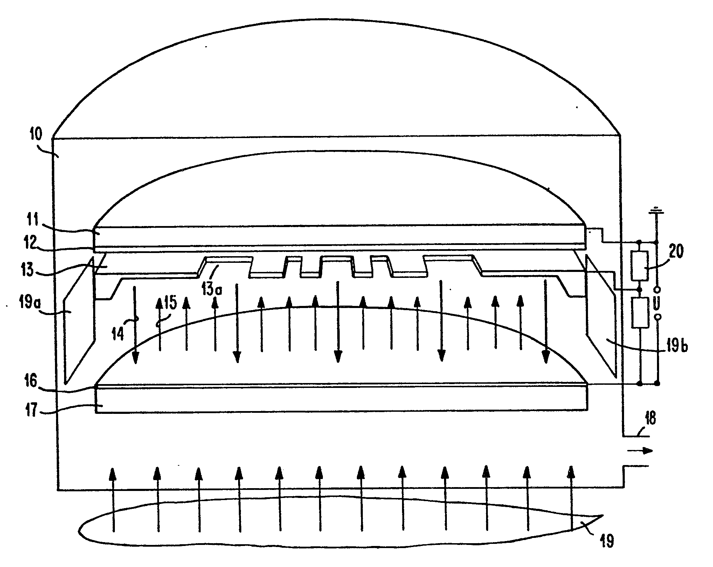

Die in der Figur angedeutete Konfiguration, bei der die Grösse der Photokathode im wesentlichen der Grösse der Maske entspricht, empfiehlt sich besonders bei solchen Lithographieprozessen, die nur einen Maskenschritt erfordern, wie es beispielsweise der Fall ist bei magnetischen Domänenspeichern, den sog. Bubbles. Bei anderen lithographischen Herstellprozessen, insbesondere der Halbleitertechnologie, müssen dagegen mehrere Masken zu verschiedenen Zeitpunkten auf denselben Wafer projiziert werden, nachdem die Maske auf die dort schon vorhandenen Strukturen ausgerichtet wurde. Zur Erleichterung dieser sog. Registrierung werden in der Vakuumglocke 10 zusätzliche elektrostatische Ablenkelektroden 19a, 19b angebracht, die parallel zur Feldrichtung verlaufen und an die elektrische Potentiale geeigneter Grösse angelegt werden können. Mit dieser Einrichtung lässt sich der von der Photokathode ausgehende homogene Elektronenstrahl als ganzes kippen, so dass das Schattenbild der Maske auf den Wafer 11 um eine der Ablenkspannung proportionale Strecke verschoben wird. Damit kann eine schnelle Feinregistrierung durchgeführt werden.

Zur weiteren Verbesserung der Registriermöglichkeiten wird die Grösse der Photokathode so gewählt, dass sie nicht der Grösse der ganzen Maske 13 entspricht, sondern nur einer oder weniger Schaltungen, die später sog. Chips ergeben. Die gesamte Oberfläche des Wafers 14 wird dann durch schrittweises Verschieben des Belichtungssystems relativ zu seiner Oberfläche belichtet (sog. Step-and-Repeat-Verfahren). Vor jeder Belichtung kann dann mit Hilfe der Ablenkelektroden 19 eine Feinregistrierung durchgeführt werden, die auch lokale Verzerrungen ausgleicht. Zur Registrierung können die im Stand der Technik bekannten Verfahren herangezogen werden, beispielsweise die Feststellung von Röntgenstrahlen, die vom Elektronenstrahl aus speziellen Richtmarken ausgelöst werden.

## Patentansprüche

1. Einrichtung zur Elektronenstrahl-Lithographie, bei der das Schattenbild einer unmittelbar vor der zu belichtenden Fläche und parallel zu dieser angeordneten nicht anliegenden Maske übertragen wird, dadurch gekennzeichnet, dass die Maske (13) mit einem homogenen kollimierten Elektronenstrahlenbündel (15) beaufschlagt wird, das von einer grossflächigen unstrukturierten Photokathode (16) ausgeht, und dass das Elektronenstrahlenbündel (15) durch ein elektrisches Feld (14) zwischen Photokathode (16) und zu belichtender Fläche (12) kollimiert wird.

2. Einrichtung nach Anspruch 1, dadurch gekennzeichnet, dass die Abmessungen der Oberfläche der Photokathode im wesentlichen den Abmessungen der zu belichtenden Fläche der Maske (13) entsprechen.

3. Einrichtung nach Anspruch 1, dadurch gekennzeichnet, dass die Abmessungen der Oberfläche der Photokathode (16) den Abmessungen von Teilausschnitten der Maske (13) entsprechen und dass die zu belichtende Oberfläche (12) schrittweise an der Maske vorbeigeführt wird.

4. Einrichtung nach einem der Ansprüche 1 bis 3, dadurch gekennzeichnet, dass der Maske (13) ein elektrisches Potential so aufgeprägt wird, dass die Maske einer Äquipotentialfläche desjenigen elektrischen Feldes entspricht, das zwischen Photokathode (16) und der als Anode wirkenden, zu belichtenden Fläche (12) vorliegt, wenn keine Maske eingebaut ist.

5. Einrichtung nach einem der Ansprüche 1 bis 4, dadurch gekennzeichnet, dass zwei oder mehrere elektrostatische Ablenkelektroden (19a, 19b) parallel zur Richtung des elektrischen Feldes (14) vorgesehen sind und zur Kippung des Elektrodenstrahles wahlweise mit Ablenkpotentialen beaufschlagt werden können.

6. Einrichtung nach einem der Anprüche 1 bis 5, dadurch gekennzeichnet, dass die Maske (13) und das zu belichtende Substrat beide aus Silicium bestehen.

## Claims

1. System for electron beam lithography, wherein the shadow image is transferred to a mask positioned immediately in front of and parallel to the surface to be exposed, characterized in that the mask (13) is subjected to a homogeneous collimated electron beam (15) emanating from a large-area unstructured photocathode (16), and that the electron beam (15) is collimated by an elctric field (14) between the photocathode (16) and the surface to be exposed (12).

2. System according to claim 1, characterized in that the dimensions of the surface of the photocathode substantially correspond to the dimensions of the area of the mask (13) to be exposed.

3. System according to claim 1, characterized in that the dimensions of the surface of the photocathode (16) correspond to partial sections of the mask (13), and that the surface to be exposed is moved in steps past the mask.

4. System according to any one of the claims 1 to 3, characterized in that an electric potential is impressed upon the mask (13) such that the mask corresponds to an equipotential area of the electric field between the photocathode (16) and the surface (12) to be exposed, which acts as an anode, when no mask is installed.

5. System according to any one of the claims 1 to 4, characterized in that two or several electrostatic deflecting electrodes (19a, 19b) are provided parallel to the direction of the electric field (14) and, for tilting the electrode beam, may be selectively subjected to deflection potentials.

6. System according to any one of the claims 1 to 5, characterized in that the mask (13) and the substrate to be exposed are both made of silicon.

## Revendications

1. Dispositif pour réaliser la lithographie utilisant un faisceau d'électrons, et dans lequel on réalise la transmission de l'image ombrée d'un masque disposé directement en avant de la surface devant être exposée et parallèlement à cette dernière, sans être en contact avec elle, caractérisé en ce que
– on envoie sur le masque (13) un faisceau d'électrons (15) collimaté et homogène, qui part d'une photocathode (16) non structurée, de surface étendue, et
– que le faisceau d'électrons (15) est collimaté par un champ électrique (14) entre la photocathode (16) et la surface (12) devant être exposée.

2. Dispositif selon la revendication 1, caractérisé en ce que les dimensions de la surface de la photocathode correspondent essentiellement aux dimensions de la surface, devant être exposée, du masque (13).

3. Dispositif selon la revendication 1, caractérisé en ce que les dimensions de la surface de la photocathode (16) correspondent aux dimensions de parties du masque (13) et que la surface (12) devant être exposée est déplacée pas-à-pas devant le masque.

4. Dispositif selon l'une des revendications 1 à 3, caractérisé en ce qu'un potential électrique est appliqué au masque (13) de telle sorte que ce dernier corresponde à une surface équipotentielle du champ électrique qui est présent entre la photocathode (16) et la surface (12) qui doit être exposée et agit en tant qu'anode, lorsqu'aucun masque n'est installé.

5. Dispositif selon l'une des revendications 1 à 4, caractérisé en ce que deux ou plusieurs électrodes électrostatiques de déviation (19a, 19b) sont prévues parallèlement à la direction du champ électrique (14) et que des potentiels de déviation peuvent leur être appliqués, au choix, pour réaliser le pivotement du faisceau d'électrons.

6. Dispositif selon l'une des revendications 1 à 5, caractérisé en ce que le masque (13) et le substrat devant être exposé sont constitués tous les deux par du silicium.